# EUROPÄISCHE PATENTSCHRIFT

(11) **EP 3 342 185 B1**
(45) Veröffentlichungstag und Bekanntmachung des Hinweises auf die Patenterteilung: **16.11.2022**
(21) Anmeldenummer: 16750421.6
(22) Anmeldetag: 01.08.2016
(51) Int. Cl.: H04R 29/00, H04R 17/00, H04R 3/00, H04R 3/04

(54) **MEMS-SCHALLWANDLER MIT GESCHLOSSENEM REGELSYSTEM**
MEMS SOUND TRANSDUCER WITH CLOSED CONTROL SYSTEM
TRANSDUCTEUR À MEMS ÉQUIPÉ D'UN SYSTÈME DE COMMANDE EN CHAÎNE FERMÉE

(30) Priorität: 27.08.2015 DE 102015114245
(43) Veröffentlichungstag der Anmeldung: 04.07.2018
(73) Patentinhaber: Usound GmbH, 8020 Graz (AT)
(72) Erfinder: RUSCONI CLERICI BELTRAMI, Andrea, 1130 Wien (AT); BOTTONI, Ferruccio, 8020 Graz (AT)
(74) Vertreter: Canzler & Bergmeier Patentanwälte Partnerschaft mbB
(86) Internationale Anmeldenummer: PCT/EP2016/068295
(87) Internationale Veröffentlichungsnummer: WO 2017/032555

(56) Entgegenhaltungen:
- EP-A2- 1 051 058
- WO-A2-2014/045123
- DE-A1- 10 256 033
- DE-A1-102011 054 009
- DE-A1-102012 215 239
- US-A- 2 860 183
- US-A1- 2012 294 450
- US-A1- 2014 177 881

## Beschreibung

Die vorliegende Erfindung betrifft einen MEMS-Lautsprecher zum Erzeugen von Schallwellen im hörbaren Wellenlängenspektrum mit einem Tragelement, insbesondere einem Membrantragrahmen, einer gegenüber dem Tragelement entlang einer z-Achse auslenkbaren Membran, zumindest einem sich am Tragelement abstützenden piezoelektrischen Aktuator zum Auslenken der Membran und einer elektronischen Steuereinheit zum Ansteuern des Aktuators.

Die Bezeichnung MEMS steht für mikroelektromechanische Systeme. Derartige Systeme werden besonders in elektronischen Geräten verbaut, die nur wenig Bauraum bieten. Die Performance bekannter MEMS-Lautsprecher ist größtenteils von idealen Umgebungsbedingungen abhängig. Schon kleine Schläge oder andere Umwelteinflüsse, wie Temperatur oder Luftdruck, können sich dabei nachteilig auf die Leistungsfähigkeit des Systems auswirken. Ferner können Alterungseffekte die Leistungsfähigkeit derartiger MEMS-Lautsprecher negativ beeinflussen. Die heutigen Anforderungen an derartige MEMS-Lautsprecher verlangen jedoch langfristig auch bei sich verändernden äußeren Einflüssen eine zumindest gleichbleibende Klangqualität.

Die US 2014/0177881 A1 offenbart eine Membranvorrichtung mit einem Träger, einer an dem Träger aufgehängten Membran, einem ersten Aktuator, der mit der Membran in Kontakt steht, um eine Kraft auf die Membran auszuüben, einem zweiten Aktuator, der mit der Membran in Kontakt steht, um eine Kraft auf die Membran auszuüben, Mittel zum Bestimmen der Position der Membran relativ zum Träger und Steuermittel für den ersten und zweiten Aktuator, wobei die Steuermittel ein Verformungssignal an den ersten oder zweiten Aktuator anlegen, um die Membran zu verformen, und ein Steuersignal an den jeweils anderen Aktuator anlegen, um die Verschiebung der Membran zu steuern, wobei das Anlegen des Steuersignals durch die Membranposition bestimmt wird.

Aus der US 2012/0294450 A1 ist eine Wandlervorrichtung bekannt, die einen Prozessor und einen Speicher, der einen Computerprogrammcode enthält, umfasst, wobei der Speicher und der Computerprogrammcode so beschaffen sind, dass sie zusammen mit dem mindestens einen Prozessor bewirken, dass die Vorrichtung mindestens Folgendes durchführt: Überwachen mindestens eines Indikators in Abhängigkeit von einem mechanischen Integrationsparameter des Wandlers und Bestimmen einer Änderung des mindestens einen Indikators.

Ferner sind aus der US 2,860,183 A, EP 1 051 058 A2, DE 10 2011 054 009 A1 und WO 2014/045123 A2 Vorrichtungen zur Überwachung von Lautsprechern bekannt.

Aufgabe der vorliegenden Erfindung ist es, einen MEMS-Lautsprecher zu schaffen, mit dem die aus dem Stand der Technik bekannten Nachteile beseitigt werden können, insbesondere einen MEMS-Lautsprecher zu schaffen, der im Vergleich zu den aus dem Stand der Technik bekannten eine höhere Lebensdauer, eine verbesserte Leistungsfähigkeit und/oder eine verbesserte Klangqualität aufweist.

Die Aufgabe wird gelöst durch einen MEMS-Lautsprecher mit den Merkmalen des unabhängigen Patentanspruchs 1.

Vorgeschlagen wird ein MEMS-Lautsprecher zum Erzeugen von Schallwellen im hörbaren Wellenlängenspektrum. Der MEMS-Lautsprecher weist ein Tragelement und eine gegenüber dem Tragelement entlang einer z-Achse auslenkbare Membran auf. Das Tragelement kann hierbei ein Tragrahmen sein. Die Membran überspannt vorzugsweise eine Aussparung des Tragrahmens, so dass die Membran gegenüber dem Tragrahmen zur Erzeugung von Schallwellen in z-Richtung auslenkbar ist. Des Weiteren umfasst der MEMS-Lautsprecher zumindest einen sich am Tragelement abstützenden piezoelektrischen Aktuator zum Auslenken der Membran. Der piezoelektrische Aktuator ist hierbei als Kantilever bzw. Kragarm ausgebildet. Demnach ist eines seiner beiden Enden fest am Tragelement befestigt, wo hingegen das freie Ende in z-Richtung auslenkbar ist. Mit dem gegenüber dem Tragelement frei beweglichen anderen Ende ist der Aktuator mittelbar über eine Tragstruktur mit der Membran verbunden, so dass beim Auslenken des Aktuators zugleich die Membran in z-Achse ausgelenkt wird. Der piezoelektrische Aktuator umfasst vorzugsweise zumindest eine piezoelektrische Schicht.

Außerdem umfasst der MEMS-Lautsprecher eine elektronische Steuereinheit zum Ansteuern des Aktuators. Der MEMS-Lautsprecher weist ferner zumindest einen Positionssensor auf. Mit diesem ist mittelbar die Position bzw. Auslenkung der Membran entlang der Z-Achse erfassbar. Der Positionssensor ist ein piezoelektrischer Sensor. Mittels des Positionssensors ist der Steuereinheit ein von der Membranauslenkung abhängiges Sensorsignal bereitstellbar.

Die Steuereinheit ist mit dem zumindest einen Aktuator und Positionssensor elektrisch verbunden. Des Weiteren ist die Steuereinheit ausgebildet, um einen Funktionsselbsttest bzw. ein Funktionsselbsttest-Verfahren durchzuführen. Hierbei wird überprüft, ob der MEMS-Schallwandler, insbesondere dessen Einzelkomponenten, wie z.B. Aktuator, Positionssensor und/oder Membran, ordnungsgemäß funktioniert. Auch ist die Steuereinheit ausgebildet, um eine Verzerrungsreduktion bzw. ein Verzerrungsreduktions-Verfahren durchzuführen. Hierbei verhindert oder zumindest reduziert die Steuereinheit durch eine adäquate Ansteuerung des Aktuators Verzerrungen des MEMS-Schallwandlers bei der Klangabgabe. Außerdem ist die Steuereinheit ausgebildet, um einen Beschädigungsschutz bzw. ein Beschädigungsschutz-Verfahren durchzuführen, bei dem die bewegten Komponenten des MEMS-Schallwandlers, d.h. insbesondere der Aktuator, der Positionssensor und/oder die Membran, vor Überbelastungen und infolgedessen Beschädigungen geschützt werden. Ferner ist die Steuereinheit ausgebildet, um ein Kompensations-Verfahren durchzuführen, bei dem insbesondere durch Alterungseffekte und/oder äußere Einflüsse bedingte Verhaltensänderungen des MEMS-Lautsprechers kompensiert werden. Um das Funktionsselbsttest-Verfahren, Verzerrungsreduktions-Verfahren, Beschädigungsschutz-Verfahren und/oder Kompensations-Verfahren durchführen zu können, ist die Steuereinheit derart ausgebildet, dass das Sensorsignal zum Erhalt eines Analyseergebnisses analysierbar und/oder zum Erhalt eines Vergleichsergebnisses mit einem in der Steuereinheit abgespeicherten Referenzsignal abgleichbar ist. Die Steuereinheit analysiert demnach das Sensorsignal und/oder gleicht dieses mit dem Referenzsignal ab. Durch die Analyse des Ist-Sensorsignals können beispielsweise Eigenschaften des MEMS-Lautsprechers bestimmt werden, wie beispielsweise dessen Eigenfrequenz. Ferner kann beispielsweise eine nichtlineare Oszillation des Sensorsignals identifiziert werden.

Durch den Abgleich des Sensorsignals mit dem Referenzsignal werden bei Feststellung einer Abweichung Verhaltensänderungen des MEMS-Lautsprechers festgestellt. Derartige Verhaltensänderungen können beispielsweise durch äußere Einflüsse, insbesondere Temperatur und/oder Druckänderungen hervorgerufen werden. Ebenso können aber auch Alterungseffekte, insbesondere der piezoelektrischen Schicht des Aktuators, eine Veränderung des Verhaltens hervorrufen. So kann sich der piezoelektrische Koeffizient durch äußere Einflüsse oder Alterungseffekte degenerieren, wodurch die piezoelektrische Leistungsfähigkeit reduziert wird. Infolgedessen kann der piezoelektrische Aktuator bei einer Referenzspannung im Laufe der Zeit eine immer geringere Kraft und infolgedessen einen immer geringeren Hub der Membran hervorrufen.

Ferner können durch einen derartigen Abgleich aber auch nichtlineare Oszillationen des MEMS-Lautsprecher identifiziert werden, die eine Verzerrung des ausgegebenen Klangs hervorrufen. Aber auch Überbelastungen, die zu einer Beschädigung der bewegten Komponenten des MEMS-Lautsprechers führen können, sind durch eine derartige Analyse und/oder einen derartigen Abgleich identifizierbar.

Um eine Beschädigung des MEMS-Lautsprechers vermeiden zu können und die Klangqualität unabhängig von äußeren Einflüssen sowie Alterungseffekten auf einem gleich bleibend hohen Niveau sicherstellen zu können, ist die Steuereinheit ferner derart ausgebildet, dass der Aktuator unter Berücksichtigung des Analyseergebnisses und/oder des Vergleichsergebnisses geregelt ansteuerbar ist bzw. von der Steuereinheit geregelt angesteuert wird. Demnach ist der Aktuator bei Feststellung einer alterungsbedingten oder durch äußere Einflüsse hervorgerufenen Leistungsminderung fortan mit einer höheren elektrischen Spannung betreibbar. Hierbei wird demnach der piezoelektrische Aktuator mit einem die Leistungsminderung kompensierender höheren Spannung betrieben. Ebenso kann der piezoelektrische Aktuator aber auch bei einer festgestellten Überbelastung und/oder Verzerrung mit einer reduzierten Spannung betrieben werden. Zusammenfassend ist demnach festzustellen, dass der MEMS-Lautsprecher mit einer gemäß der vorangegangenen Beschreibung ausgebildeten Steuereinheit langlebiger und/oder über längeren Zeitraum mit gleich bleibend hoher Klangqualität betrieben werden kann.

Vorteilhaft ist es, wenn mittels der Steuereinheit zumindest ein Signalwert analysierbar und/oder mit einem Referenzwert abgleichbar ist. Zusätzlich oder alternativ ist es ferner vorteilhaft, wenn der zeitliche Signalverlauf des Sensorsignals analysierbar und/oder mit einem Referenzsignalverlauf abgleichbar ist. Dies kann vorzugsweise innerhalb eines Zeitfensters und/oder eines festgelegten Frequenzbereiches erfolgen. So ist es insbesondere vorteilhaft zumindest einen einzelnen Signalwert zu analysieren und/oder mit einem Referenzwerte abzugleichen, um ein Funktionstest durchführen zu können, eine Verhaltensänderung verstellen zu können und/oder eine Überbelastung identifizieren zu können. Des Weiteren kann insbesondere durch die Analyse und/oder den Abgleich eines Signalverlaufs für eine Verzerrungsreduktion eine nichtlineare Oszillation festgestellt werden.

Für einen Funktionsselbsttest und/oder zur Verstellung einer Verhaltensänderung ist es vorteilhaft, wenn die Steuereinheit derart ausgebildet ist, dass durch die Analyse des vom Positionssensor an die Steuereinheit übermittelter Ist-Sensorsignals ein Ist-Standardverhalten des MEMS-Lautsprechers ermittelbar ist. Dieses ermittelte Ist-Standardverhalten kann dann, insbesondere bei der ersten Inbetriebnahme des MEMS-Lautsprechers, als Referenz-Standardverhalten in einem Speicher der Steuereinheit hinterlegt sein. Dieses in einem ersten Schritt festgestellte Ist-Standardverhalten bildet dann das neue Referenzsignal bzw. das neue Soll-Standardverhalten, mittels dem durch einen erneuten Abgleich eine erneute Verhaltensveränderung des MEMS-Lautsprechers feststellbar ist.

Für einen Funktionsselbsttest ist es vorteilhaft, wenn in der Steuereinheit ein von einem Referenz-Aktuatorsignal abhängiges Soll-Sensorsignal abgespeichert ist. Dieses Soll-Sensorsignal gibt demnach das Soll-Standardverhalten des MEMS-Lautsprechers wieder.

Zum Funktionsselbsttest ist die Steuereinheit derart ausgebildet, dass der Aktuator mit dem Referenz-Aktuatorsignal, welches eine Soll-Auslenkung der Membran hervorruft bzw. erzeugt, ansteuerbar ist. Nach dieser Ansteuerung mit dem Referenz-Aktuatorsignal ist es vorteilhaft, wenn das von der Ist-Auslenkung abhängige Ist-Sensorsignal mit dem Soll-Sensorsignal abgleichbar ist. Ferner ist es vorteilhaft, wenn die Steuereinheit bei diesem Abgleich eine Abweichung des Ist-Sensorsignals vom Soll-Sensorsignal zu ermitteln vermag. Zusätzlich oder alternativ ist es vorteilhaft, wenn die Steuereinheit bei einer festgestellten Abweichung eine Fehlermeldung ausgibt und/oder an eine übergeordnete Steuereinheit meldet. Hierdurch kann der MEMS-Lautsprecher vorzugsweise selbstständig überprüfen, ob dieser ordnungsgemäß arbeitet. Falls dem nicht so ist, ist es vorteilhaft, wenn die Steuereinheit derart ausgebildet ist, dass sie fortan bei einer Ansteuerung des Aktuators über eine Anpassung der elektronischen Ansteuerung diese Verhaltensänderung kompensiert.

Des Weiteren ist es vorteilhaft, wenn die Steuereinheit derart ausgebildet ist, dass diese den Funktionsselbsttest automatisch bei einem sensorisch erkannten Ereignis durchzuführen vermag. Ein derartiges Ereignis ist insbesondere ein identifizierter Systemstart, eine sensorisch erfasste äußere Stoßeinwirkung oder eine sensorisch erfasste Verhaltensänderung des MEMS-Lautsprechers.

Beim Funktionsselbsttest ist es vorteilhaft, wenn die Steuereinheit derart ausgebildet ist, dass diese zumindest zwischen zwei Fehlerarten, insbesondere einer Aktuatorbeschädigung, einer Membranbeschädigung und/oder einer Verstopfung der Schallaustrittsöffnung, differenzieren kann. Hierdurch kann eine gezielte Gegenmaßnahme eingeleitet werden, um den identifizierten Fehler zumindest teilweise kompensieren zu können.

Nachfolgend kommen vorteilhafte Ausgestaltungen der Steuereinheit zur Verzerrungsreduktion. Demnach ist es vorteilhaft, wenn die Steuereinheit zur Verzerrungsreduktion derart ausgebildet ist, dass durch die Analyse des Ist-Sensorsignals eine nichtlineare Oszillation des MEMS-Lautsprechers ermittelbar ist. Hierfür wird vorzugsweise der zeitliche Signalverlauf des Sensorsignals analysiert. Durch eine derart identifizierte nichtlineare Oszillation können Verzerrungen festgestellt werden.

Zur Verzerrungsreduktion ist es vorteilhaft, wenn die Steuereinheit derart ausgebildet ist, dass der Aktuator mit einem die ermittelte nichtlineare Oszillation zumindest teilweise reduzierenden Kompensation-Aktuatorsignal ansteuerbar ist. Hierdurch kann die Klangqualität des MEMS-Lautsprechers verbessert werden.

Zur Realisierung eines Beschädigungsschutzes ist die Steuereinheit vorzugsweise gemäß der nachfolgenden Beschreibung ausgebildet. Demnach ist es vorteilhaft, wenn die Steuereinheit derart ausgebildet ist, dass durch die Analyse des Ist-Sensorsignals, insbesondere der Höhe zumindest eines Signalwertes, ein Maximalausschlag der Membran ermittelbar ist. Hierdurch kann eine bereits erfolgte oder unmittelbar bevorstehende Überbelastung der bewegten Komponenten des MEMS-Lautsprechers zuverlässig identifiziert werden.

Zum Beschädigungsschutz ist es ferner vorteilhaft, wenn in der Steuereinheit ein Schwellwert mit einer maximal zulässigen Schwellwerthöhe abgespeichert ist. Der Schwellwerts bzw. dessen Schwellwerthöhe definiert hierbei die maximal zulässige Auslenkung entlang der z-Achse, bis zu der der MEMS-Lautsprecher mindestens beschädigungsfrei betreibbar ist.

Zusätzlich ist es vorteilhaft, wenn die Steuereinheit zum Beschädigungsschutz des MEMS-Lautsprecher derart ausgebildet ist, dass zum Erkennen einer Überbelastung das von einer ersten Auslenkung abhängige Ist-Sensorsignal, insbesondere zumindest ein Signaleinzelwert, mit dem maximal zulässigen Schwellwert abgleichbar ist. Ferner ist es vorteilhaft, wenn die Steuereinheit ausgebildet ist, um den Aktuator bei einem identifizierten Überschreiten des Schwellwertes mit einem, insbesondere reduzierten, Aktuatorsignal ansteuerbar ist, das eine zur ersten Auslenkung reduzierte zweite Auslenkung erzeugt. Hierdurch kann vorteilhafterweise vermieden werden, dass die bewegten Komponenten des MEMS-Lautsprechers derart stark ausgelenkt werden, dass diese beschädigt werden.

Die nachfolgenden Spezifikationen der Steuereinheit sind insbesondere zum Beschädigungsschutz und/oder zur Kompensation von Verhaltensänderungen des MEMS-Schallwandlers vorteilhaft. Demnach ist es vorteilhaft, wenn die Steuereinheit zu diesem Zweck derart ausgebildet ist, dass durch die Analyse des Ist-Sensorsignals eine Ist-Eigenfrequenz des MEMS-Lautsprechers ermittelbar ist. Die Ist-Eigenfrequenz stellt hierbei eine das aktuelle Verhalten des MEMS-Lautsprechers repräsentierende Eigenschaft dar. Des Weiteren ist die Kenntnis über die Ist-Eigenfrequenz notwendig, um bei einer zeitlich zu langen Ansteuerung im Bereich der Eigenfrequenz eine Beschädigung des MEMS-Lautsprechers vermeiden zu können.

Vorteilhaft ist es, wenn in der Steuereinheit zur Ermittlung der Ist-Eigenfrequenz ein Analyse-Aktuatorsignal, insbesondere ein Rauschsignal, abgespeichert ist. Das Analyse-Aktuatorsignal erstreckt sich vorzugsweise innerhalb eines unterhalb der Resonanzfrequenz des MEMS-Lautsprechers liegenden Frequenzbereichs.

Diesbezüglich ist es ferner vorteilhaft, wenn die Steuereinheit zur Ermittlung der Ist-Eigenfrequenz derart ausgebildet ist, dass der Aktuator mit dem Analyse-Aktuatorsignal ansteuerbar ist und/oder ein die Ist-Eigenfrequenz identifizierendes Maximum innerhalb des Frequenzbereiches ermittelbar ist. Hierdurch kann schnell und mit einfachen Mitteln die Ist-Eigenfrequenz des MEMS-Lautsprechers ermittelt werden.

Zum Beschädigungsschutz und/oder zur Kompensation von Verhaltensänderungen ist es vorteilhaft, wenn in der Steuereinheit eine Referenz-Eigenfrequenz abgespeichert ist.

Ferner ist es diesbezüglich vorteilhaft, wenn die Steuereinheit zum Beschädigungsschutz und/oder zur Kompensation von Verhaltensänderungen derart ausgebildet ist, dass die ermittelte Ist-Eigenfrequenz des MEMS-Lautsprechers mit der hinterlegten Referenz-Eigenfrequenz abgleichbar ist.

Zusätzlich oder alternativ ist es ferner vorteilhaft, wenn bei einer Abweichung der Ist-Eigenfrequenz von der Referenz-Eigenfrequenz die ermittelte Ist-Eigenfrequenz als neue Referenz-Eigenfrequenz abspeicherbar ist.

Diesbezüglich ist es vorteilhaft, wenn die Steuereinheit zum Beschädigungsschutz und/oder zur Kompensation von Verhaltensänderungen derart ausgebildet ist, dass die Ansteuerung des Aktuators unter Berücksichtigung der neuen Referenz-Eigenfrequenz erfolgt. Demnach kann die neu ermittelte und abgespeicherte Referenz-Eigenfrequenz nunmehr berücksichtigt werden, um zur Vermeidung einer Überbelastung den MEMS-Lautsprecher im Bereich der neuen Eigenfrequenz zeitlich reduziert anzusteuern. Des Weiteren dient die neue abgespeicherte Referenz-Eigenfrequenz dazu, um im Laufe der Zeit Weitere Verhaltensänderungen identifizieren zu können.

Vorgeschlagen wird insbesondere ein MEMS-Lautsprecher-Verfahren zum Funktionsselbsttest, zur Verzerrungsreduktion, zum Beschädigungsschutz und/oder zur Kompensation von Verhaltensänderungen, bei welchem über zumindest einen Positionssensor ein von einer Membranauslenkung abhängiges Sensorsignal erfasst wird, das Sensorsignal an eine Steuereinheit übermittelt wird, die Steuereinheit das Sensorsignal analysiert und/oder mit einem in der Steuereinheit abgespeicherten Referenzsignal abgleicht und unter Berücksichtigung des Analyseergebnisses und/oder Vergleichsergebnisses einen Aktuator geregelt ansteuert. Das Verfahren wird mit einem MEMS-Lautsprecher gemäß der vorangegangenen Beschreibung durchgeführt, wobei der MEMS-Lautsprecher, nämlich dessen Steuereinheit, ein Funktionsselbsttest-Verfahren, durchführt.

Weitere Vorteile der Erfindung sind in den nachfolgenden Ausführungsbeispielen beschrieben. Es zeigen:
- **Figur 1**: eine perspektivische Schnittansicht eines MEMS-Lautsprechers, gemäß einem Ausführungsbeispiel der vorliegenden Erfindung,
- **Figur 2**: eine schematische Draufsicht eines Ausführungsbeispiels eines piezoelektrischen Aktuators mit integriertem Positionssensor,
- **Figur 3**: eine schematische Draufsicht eines zweiten Ausführungsbeispiels eines piezoelektrischen Aktuators mit integriertem Positionssensor,
- **Figur 4**: eine schematische Seitenansicht des zweiten Ausführungsbeispiels eines piezoelektrischen Aktuators mit integriertem Positionssensor,
- **Figur 5**: eine schematische Draufsicht eines dritten Ausführungsbeispiels eines piezoelektrischen Aktuators mit einem nicht durch die Ansprüche abgedeckten piezoresistivem Positionssensor,
- **Figur 6**: eine schematische Draufsicht eines vierten Ausführungsbeispiels eines piezoelektrischen Aktuators mit einem nicht durch die Ansprüche abgedeckten kapazitivem Positionssensor und
- **Figur 7**: die Arbeitsweise des MEMS-Lautsprechers veranschaulichende schematische Darstellung des Informationsfußes zwischen Steuereinheit, Aktuator und Positionssensor.

Bei der nachfolgenden Figurenbeschreibung werden, um die Beziehungen zwischen den verschiedenen Elementen zu definieren, bezugnehmend auf die jeweils in den Figuren dargestellte Lage der Objekte relative Begriffe, wie beispielsweise oberhalb, unterhalb, oben, unten, drüber, drunter, links, rechts, vertikal und horizontal, verwendet. Es versteht sich von selbst, dass sich diese Begrifflichkeiten bei einer Abweichung von der in den Figuren dargestellten Lage der Vorrichtungen und/oder Elemente verändern können. Demnach würde beispielsweise bei einer in Bezug auf die Figuren dargestellten invertierten Orientierung der Vorrichtungen und/oder Elemente ein in der nachfolgenden Figurenbeschreibung als oberhalb spezifiziertes Merkmal nunmehr unterhalb angeordnet sein. Die verwendeten Relativbegriffe dienen somit lediglich zur einfacheren Beschreibung der relativen Beziehungen zwischen den einzelnen im nachfolgenden beschriebenen Vorrichtungen und/oder Elemente.

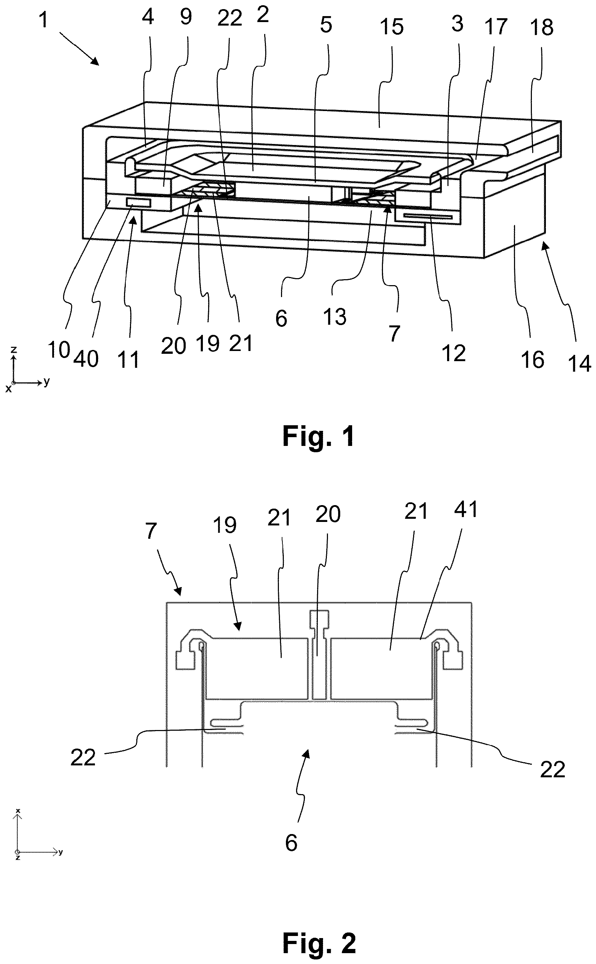

Figur 1 zeigt ein erstes Ausführungsbeispiel eines MEMS-Lautsprechers, der vorzugsweise als MEMS-Lautsprecher 1 ausgebildet ist. Alternativ könnte dieser aber auch insbesondere als MEMS-Mikrofon ausgebildet sein.

Der MEMS-Lautsprecher 1 ist zum Erzeugen von Schallwellen im hörbaren Wellenlängenspektrum ausgebildet. Hierzu besitzt der MEMS-Lautsprecher 1 eine Membran 2 und einen Membranträger 3. Die Membran 2 ist in ihrem Randbereich 4 mit dem Membranträger 3 verbunden und vermag gegenüber dem Membranträger 3 entlang einer z-Achse zu schwingen. Die z-Achse verläuft dabei im Wesentlichen senkrecht zur Membran 2. An der Unterseite der Membran 2 ist ein Verstärkungselement 5 angeordnet.

Der MEMS-Lautsprecher 1 weist neben der Membran 2 eine Hubstruktur 6, die mit der Membran 2 gekoppelt ist, und zumindest einen piezoelektrischen Aktuator 7 auf. Der Aktuator 7 ist über eine Hubstruktur 6 mit der in z-Richtung bewegbaren Membran 2 verbunden. Der Membranträger 3 ist an einem Trägersubstrat 9 des piezoelektrischen Aktuators 7 angeordnet. Der piezoelektrische Aktuator 7 ist unterhalb der Membran 2 und/oder im Wesentlichen parallel zu dieser angeordnet. Der piezoelektrische Aktuator 7 ist ausgebildet, um eine uni- oder bidirektionale Hubbewegung der Hubstruktur 6 hervorzurufen, um die Membran 2 auszulenken. Er wirkt mit der Membran 2 zusammen, um elektrische Signale in akustisch wahrnehmbare Schallwellen zu wandeln. Der piezoelektrische Aktuator 7 bzw. die piezoelektrische Aktuatorstruktur ist an einer der Membran 2 abgewandten Seite des Trägersubstrates 9 angeordnet.

Des Weiteren umfasst der MEMS-Lautsprecher 1 eine Leiterplatte 10. In die Leiterplatte 10 ist eine elektronische Steuereinheit 11, insbesondere ein ASIC, vollständig eingebettet. Die Steuereinheit 11 ist somit vollständig gekapselt. Zusätzlich zu der Steuereinheit 11 können auch weitere passive Komponenten 12, wie elektrische Widerstände und/oder E/A-Kontakte, in die Leiterplatte 10 eingebettet und/oder an dieser angeordnet sein. Der MEMS-Lautsprecher 1 und insbesondere der piezoelektrische Aktuator 7 sind mit in den Figuren nicht weiter dargestellten elektrischen Kontakten mit der Steuereinheit 11 verbunden. Der MEMS-Lautsprecher 1 kann somit über die Steuereinheit 11 angesteuert bzw. betrieben werden, so dass durch den piezoelektrischen Aktuator 7 die Membran 2 zur Erzeugung von Schallenergie gegenüber dem Membranträger 3 in Schwingung versetzt wird. Der piezoelektrische Aktuator 7 ist dabei als Kragarm 13 ausgebildet. Er hat demnach ein fest eingespanntes und ein frei schwingendes Ende.

Der MEMS-Lautsprecher 1 ist gemäß Figur 1 in einem Gehäuse 14 angeordnet. Das Gehäuse 14 umfasst einen oberen Gehäuseteil 15 und einen unteren Gehäuseteil 16. Der obere Gehäuseteil 15 bildet einen Schalleitkanal 17 mit einer akustischen Ein-/Austrittsöffnung 18 aus. Diese ist seitlich an einer Außenfläche des MEMS-Lautsprechers 1 angeordnet. Das Gehäuse 14 bietet insbesondere einen zusätzlichen Schutz für die Membran 2, da es diese gegenüber der Umgebung abdeckt.

Der MEMS-Lautsprecher 1 weist zumindest einen Positionssensor 19 auf. Der Positionssensor 19 ist ausgebildet, um der elektronischen Steuereinheit 11 ein von der Membranauslenkung abhängiges Sensorsignal bereitzustellen. Die Steuereinheit 11 ist ausgebildet, um den Aktuator 7 basierend auf dem Sensorsignal geregelt anzusteuern. Der Positionssensor 19 ist zu diesem Zweck ein piezoelektrischer Sensor. Der Positionssensor 19 ist zumindest teilweise in dem Aktuator 7, nämlich in dem Kragarm 13, integriert.

Bei dem in Figur 1 dargestellten Ausführungsbeispiel kann der Positionssensor 19 gemäß der in den Figuren gezeigten nachfolgenden Ausführungsbeispiele ausgebildet sein. Demnach ist der Positionssensor 19 und der piezoelektrische Aktuator 7 gemäß dem in Figur 2 dargestellten Ausführungsbeispiel durch eine gemeinsame piezoelektrische Schicht 41 gebildet (vgl. Figur 2). Die piezoelektrische Schicht 41 ist aus Blei-Zirkonat-Titanat (PZT) ausgebildet. Zumindest ein Bereich ist ein Sensorbereich 20, durch welchen zwei Aktuatorbereiche 21 voneinander beabstandet angeordnet sind. Die Sensor- und Aktuatorbereiche 20, 21 sind elektrisch voneinander isoliert. Da sich die Anforderungen für Sensorik und Aktuatorik unterscheiden können, ist auch eine Kombination verschiedener piezoelektrischer Materialien mit unterschiedlichen Eigenschaften denkbar. Dabei kann der Sensorbereich 20 aus PZT und der Aktuatorbereich 21 aus Aluminiumnitrid (AIN) ausgebildet sein.

Der Sensorbereich 20 ist gemäß Figur 2 zwischen den beiden Aktuatorbereichen 21 angeordnet und erstreckt sich symmetrisch in Kramarmlängsrichtung. Die Aktuatorbereiche 21 sind durch den Sensorbereich 20 vollständig voneinander getrennt. Der Sensorbereich 20 und der Aktuatorbereich 21 weisen in Kragarmlängsrichtung die gleiche Länge auf. Die beiden Aktuatorbereiche 21 sind flächenmäßig größer als der Sensorbereich 20.

Bei einer Auslenkung der Membran 1 über den Aktuator 7 wird nun deren Position bzw. Auslenkung in z-Richtung mittels des Positionssensors 19 erfasst. Dabei wird die über den piezoelektrischen Effekt generierte Spannung, welche näherungsweise proportional zur Auslenkung der Hubstruktur 6 ist, über die Aktuator-Elektroden abgegriffen und entsprechend ausgewertet. Die Steuereinheit 11 bestimmt anhand dieses erfassten Eingangssignals die Ist-Position bzw. Ist-Auslenkung der Membran 2. Dabei werden die elastischen Schwingungseigenschaften eines Verbindungselements 22 berücksichtigt. Das Verbindungselement 22 verbindet ein freies Ende des Positionssensors 19 mit der Hubstruktur 6. In Abhängigkeit dieser erfassten Ist-Position der Membran 2 bestimmt die Steuereinheit 11 eine gewünschte Soll-Position der Membran und/oder ein davon abhängiges elektronisches Ausgangssignal. Das Ausgangssignal wird an den Aktuator 7 übermittelt, der die Membran 2 entsprechend auslenkt. Während und/oder am Ende der Auslenkbewegung wird über den Positionssensor 19 erneut die tatsächliche Ist-Position der Membran 2 erfasst und gegebenenfalls gemäß der vorangegangenen Beschreibung erneut an die Umgebungsbedingungen angepasst.

Figur 2 zeigt, wie bereits vorstehend erwähnt, eine schematische Draufsicht eines ersten Ausführungsbeispiels eines piezoelektrischen Aktuators 7 mit integriertem Positionssensor 19. Der piezoelektrische Aktuator 7 weist dabei zwei Aktuatorbereiche 21 auf, die durch den Sensorbereich 20 voneinander getrennt sind. Beide Bereiche 20, 21 sind aus PZT ausgebildet. Es sind jedoch auch andere piezoelektrische Materialien denkbar. Dabei wäre es auch denkbar, dass ein großer Teil für die Aktorik und nur ein kleiner Bereich für den Sensor verwendet wird. Der Sensorbereich 20 ist dabei elektrisch von den Aktuatorbereichen 21 isoliert. Um einer ungewollten Verkippung der Hubstruktur 6 aufgrund eines asymmetrischen Antriebs vorzubeugen, sollten die Aktuator- und Sensorbereiche 21, 20 jeweils paarweise gegenüber angeordnet sein.

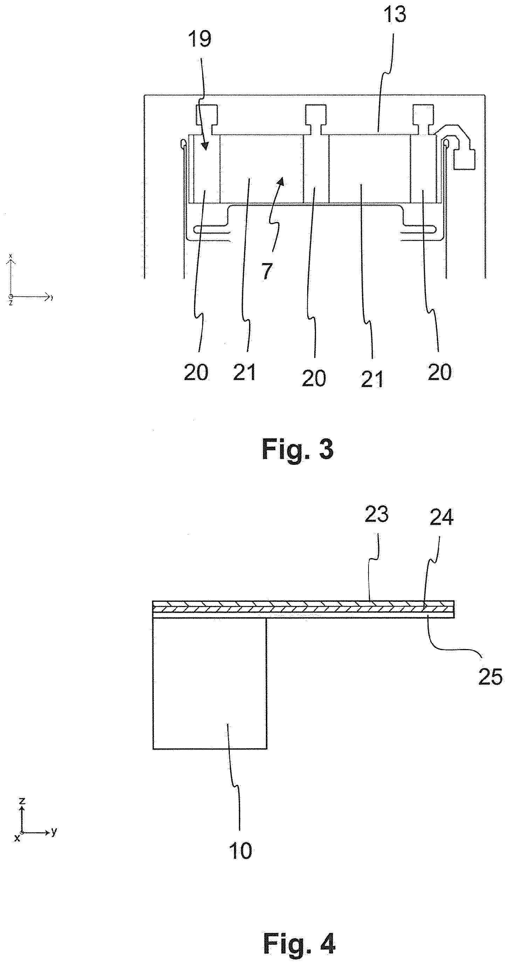

Die Figuren 3 und 4 zeigen jeweils eine schematische Ansicht eines zweiten Ausführungsbeispiels des piezoelektrischen Aktuators 7 mit Positionssensor 19. Der piezoelektrische Positionssensor 19 ist dabei gemäß Figur 4 durch eine erste piezoelektrische Schicht 23, insbesondere aus AIN, ausgebildet. Der piezoelektrische Aktuator 7 ist durch eine zweite piezoelektrische Schicht 24, insbesondere aus PZT, ausgebildet. Die beiden Schichten sind voneinander elektrisch isoliert und in Bezug zur z-Achse übereinander angeordnet.

Die erste piezoelektrische Schicht 23 ist gemäß Figur 3 in mehrere Sensorbereiche 20 unterteilt. Die Sensorbereiche 20 sind voneinander getrennt und/oder elektrisch isoliert. In dem in Figur 3 dargestellten Ausführungsbeispiel sind drei Sensorbereiche 20 ausgebildet, die in Kragarmquerrichtung voneinander beabstandet angeordnet sind. Dies erfolgt insbesondere äquidistant. Die zweite piezoelektrische Schicht 24 weist einen sich über den Kragarm 13 erstreckenden Aktuatorbereich 21 auf. Dieser Aktuatorbereich 21 erstreckt sich zumindest in einer Draufsicht vollflächig über den Kragarm 13. Die beiden Aktuatorbereiche 21 weisen in Kragarmlängsrichtung die gleiche Länge auf. Es ist jedoch auch denkbar, dass sich der Sensorbereich 20 nicht über die gesamte Kragarmlängsrichtung erstreckt, sondern nur über einen Teil davon. In diesem Fall würde die Differenz zur Kragarmlänge durch einen weiteren nicht dargestellten Aktuatorbereich ausgebildet sein.

Wie in Figur 4 dargestellt, bilden beide piezoelektrischen Schichten 23, 24 einen Stapel aus, der von einer Tragschicht 25 getragen wird. Die Tragschicht 25 ist mit der Leiterplatte 10 verbunden. Im dargestellten Ausführungsbeispiel ist die erste piezoelektrische Schicht 23, welche den Positionssensor 19 ausbildet über der zweiten piezoelektrischen Schicht 24, insbesondere dem Aktuator 7, angeordnet. Die erste piezoelektrische Schicht 23 könnte jedoch auch unter dem piezoelektrischen Aktuator 7 angeordnet sein.

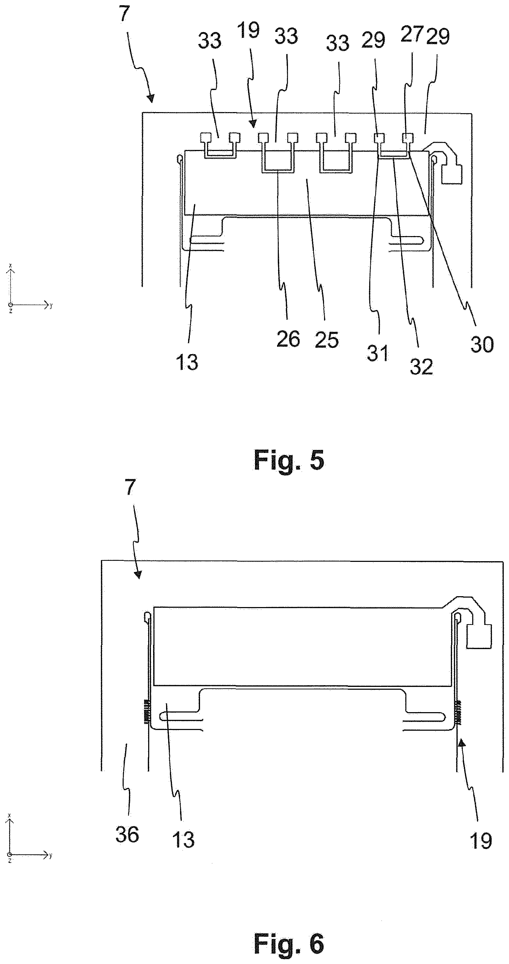

Figur 5 zeigt eine schematische Draufsicht eines nicht durch die Ansprüche abgedeckten dritten Ausführungsbeispiels eines piezoelektrischen Aktuators 7 mit integriertem piezoresistivem Positionssensor 19. Der Positionssensor 19 ist dabei piezoresistiv, insbesondere durch eine Stromleitung 26, ausgebildet. Die Stromleitung 26 ist durch ein lonenimplantationsverfahren in der Tragschicht 25 des piezoelektrischen Aktuators 7 ausgebildet. Die Stromleitung 26 erstreckt sich von einem ersten elektrischen Kontakt 27 zu einem zweiten elektrischen Kontakt 28. Die beiden elektrischen Kontakte 27, 28 sind vorzugsweise im Bereich des fest eingespannten Endes 29 des Aktuators 7 angeordnet. Die Stromleitung 26 ist u-förmig ausgebildet und weist einen ersten Längsteil 30 und einen zweiten Längsteil 31 auf. Der erste Längsteil 30 erstreckt sich vom ersten elektrischen Kontakt 27 ausgehend in Kragarmlängsrichtung in den Kragarm 13 hinein. Der zweite Längsteil 31 erstreckt sich von einem Querteil 32 ausgehend in Kragarmlängsrichtung aus dem Kragarm 13 hinaus zum zweiten elektrischen Kontakt 28, wobei sich das Querteil 32 in Kragarmquerrichtung erstreckt. Auf die soeben beschriebene Weise sind vorliegend vier derartige elektrische Widerstände 33 ausgebildet. Die Widerstände 33 sind zueinander unterschiedlich und derart mit der Steuereinheit 11 verbunden, dass eine Wheatstonesche Messbrücke ausgebildet ist.

Die Stromleitungen 26, insbesondere die Widerstände 33, reagieren dabei auf Verformungen, die infolge der Druckveränderung, welche aus der Membranauslenkung resultiert, entstehen. Die Widerstände 33 reagieren darauf mit einer Widerstandänderung, die von der Steuereinheit 11 erfasst und ausgewertet wird.

Die Figur 6 zeigt eine schematische Draufsicht eines nicht durch die Ansprüche abgedeckten vierten Ausführungsbeispiels des piezoelektrischen Aktuators 7 mit integriertem kapazitivem Positionssensor 19. Der kapazitive Positionssensor 19 weist hier nicht weiter im Detail dargestellt Aussparungen auf, in welchen jeweils ein Fortsatz angeordnet ist. Jeder Fortsatz ist in z-Richtung bewegbar. Im dargestellten Ausführungsbeispiel sind die Aussparungen an einem Rahmen 36 und die Fortsätze am Kragarm 13 angeordnet. Der Kragarm 13 ist ebenso in z-Richtung auslenkbar. Der Rahmen 36 hingegen ist ortsfest und wird vorzugsweise durch das Trägersubstrat 9 ausgebildet. Es ist jedoch auch denkbar, dass die Aussparungen im Kragarm 13 und die Fortsätze am Rahmen 36 ausgebildet sind. Die Aussparung weist zwei Innenflächen auf, wobei zumindest eine der Innenflächen als erste Messelektrode ausgebildet ist. Der Fortsatz ist entweder als zweite Messelektrode oder als Dielektrikum ausgebildet. Auf diese Weise wird ein elektrischer Kondensator ausgebildet.

Infolge einer Anregung der Membran 2 durch den Aktuator 7, werden die Fortsätze am Kragarm 13 ebenso ausgelenkt. Der Abstand der einzelnen Fortsätze zur jeweilig korrespondierenden Aussparung vergrößert sich daraufhin. Folglich vergrößert sich auch der Abstand der beiden Messelektroden bzw. der Abstand der ersten Messelektrode zum Dielektrikum. Da die Kapazität durch eben diesen Abstand bestimmt wird, erfasst die Steuereinheit 11 infolge der Auslenkung eine Kapazitätsänderung. In Abhängigkeit dieses kapazitiven Sensorsignals kann der Aktuator 7 geregelt angesteuert werden, um die Membran 2 geregelt anzusteuern (vgl. hierzu auch Figur 1).

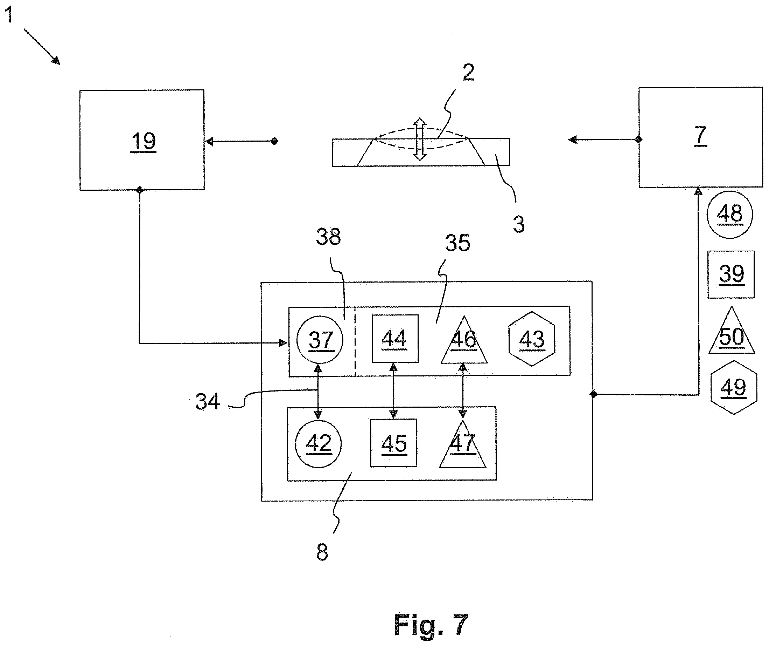

Figur 7 zeigt schematisch die Arbeitsweise des MEMS-Lautsprechers. Der MEMS-Lautsprecher umfasst hierbei die Membran 2, welche in dem Tragelement bzw. Membranträger 3 in z-Richtung auslenkbar gelagert ist. Des Weiteren umfasst der MEMS-Lautsprecher den piezoelektrischen Aktuator 7 sowie den Positionssensor 19. Diese sind wiederum mit der Steuereinheit 11 elektrisch verbunden.

Die Steuereinheit 11 ist ausgebildet, um Verhaltensveränderungen des MEMS-Lautsprechers zu erkennen und zu kompensieren. Hierfür ist die Steuereinheit 11 derart ausgebildet, dass sie das Ist-Sensorsignal 37 zu analysieren vermag und/oder mit einem in der Steuereinheit 11 abgespeicherten Referenzsignal 8 abzugleichen vermag. Des Weiteren ist die Steuereinheit 11 derart ausgebildet, dass der Aktuator 7 unter Berücksichtigung eines Analyseergebnisses 35, das durch die Analyse des Ist-Sensorsignals 37 ermittelt werden kann, und/oder Vergleichsergebnisses geregelt ansteuerbar ist.

Zum Funktionsselbsttest bzw. zur Durchführung eines Funktionsselbsttest-Verfahrens (vgl. Kreiselemente 37, 42, 48) steuert der MEMS-Lautsprecher demnach den Aktuator 7 mit einem Referenz-Aktuatorsignal 48 an. In der Speichereinheit der Steuereinheit 11 ist als Referenzsignal 8 ein Soll-Sensorsignal 42 hinterlegt, das eine vom Referenz-Aktuatorsignal 48 abhängige Soll-Auslenkung der Membran 2 repräsentiert. Durch die Ansteuerung der Membran 2 mittels des Aktuators 7 mit dem Referenz-Aktuatorsignal 48 wird diese ausgelenkt. Die Auslenkung wird über den Positionssensor 19 erfasst, der an die Steuereinheit 11 ein Ist-Sensorsignal 37 übermittelt. Das Ist-Sensorsignals repräsentiert das Ist-Standardverhalten 38 und/oder dient dazu das Ist-Standardverhalten 38 des MEMS-Lautsprechers zu ermitteln. Im Rahmen eines Ist-/Sollwertabgleichs vergleicht die Steuereinheit 11 das Ist-Sensorsignal 37 mit dem abgespeicherten Soll-Sensorsignal 42. Sofern das Vergleichsergebnis 34 keinen Unterschied zwischen den beiden Signalen ergibt, arbeitet der MEMS-Lautsprecher ordnungsgemäß. Andernfalls erkennt die Steuereinheit 11 eine fehlerhafte Arbeitsweise. Einen vorstehend beschriebenen Funktionsselbsttest bzw. ein derartiges Funktionsselbsttest-Verfahren führt die Steuereinheit 11 automatisch, insbesondere beim Systemstart oder nach äußeren Störeinwirkungen, durch.

Des Weiteren ist die Steuereinheit 11 derart ausgebildet, dass sie das eingehende Ist-Sensorsignal 37 zu analysieren vermag. Als Analyseergebnisse 35 kann die Steuereinheit 11 insbesondere einen Maximalausschlag 44, eine Ist-Eigenfrequenz 46 und/oder eine nichtlineare Oszillation 43 des MEMS-Lautsprechers ermitteln. Des Weiteren hat die Steuereinheit 11, insbesondere in einem Speicher, einen Schwellwert 45 und/oder eine Referenz-Eigenfrequenz 47 abgespeichert.

Im Rahmen einer Verzerrungsreduktion bzw. eines Verzerrungsreduktions-Verfahrens (vgl. Hexagonelemente 43, 49) kann die Steuereinheit 11 demnach durch eine Analyse des Ist-Sensorsignals 37 eine nichtlineare Oszillation 43 der Membran 2 erkennen. Derartige nichtlineare Oszillationen sind ein Indiz für eine Verzerrung des ausgegebenen Klangs. Bei der Analyse und/oder beim Abgleich des Ist-Sensorsignals 37 verwendet die Steuereinheit 11 insbesondere zumindest einen einzelnen Signalwert und/oder den zeitlichen Signalverlauf, insbesondere innerhalb eines Frequenzbereiches, des Sensorsignals.

Um diese identifizierte Verzerrung kompensieren zu können, ist die Steuereinheit 11 ferner derart ausgebildet, dass sie den Aktuator 7 mit einem - die ermittelte nichtlineare Oszillation 43 zumindest teilweise reduzierenden - Kompensation-Aktuatorsignal 49 anzusteuern vermag. Hierdurch kann die Membran 2 wieder in einen nicht verzerrenden Auslenkungsbereich zurückgeführt werden.

Zur Durchführung eines Beschädigungsschutz-Verfahrens, um eine Beschädigung der Membran 2, des Aktuators 7 und/oder des Positionssensors 19 aufgrund einer Überbelastung vermeiden zu können, ist die Steuereinheit 11 ferner derart ausgebildet, dass diese zunächst durch eine Analyse des Ist-Sensorsignals 37 und durch einen Abgleich mit einem Schwellwert 45 eine entsprechende Überbelastung identifizieren kann (vgl. Quadratelemente 39, 44, 45). Demnach definiert der Schwellwert 45 eine maximal zulässige Schwellwerthöhe, bis zu der der MEMS-Lautsprecher mindestens beschädigungsfrei betrieben werden kann.

Durch den Abgleich von Maximalausschlag 44 und Schwellwert 45 kann die Steuereinheit 11 feststellen, ob eine Überbelastung unmittelbar bevorsteht oder bereits eingetreten ist. Kurz bevor der Maximalausschlag 44 den Schwellwert 45 überschreitet oder unmittelbar nachdem er diesen überschritten hat, steuert die Steuereinheit 11 den Aktuator 7 mit einem reduzierten Aktuatorsignal 39 an. Dieses im Vergleich zum vorherigen Aktuatorsignal reduzierte Aktuatorsignal 39 bewirkt demnach eine zur ersten Auslenkung der Membran 2 reduzierte zweite Auslenkung. Hierdurch kann vorteilhafterweise eine Überbelastung der bewegten MEMS-Komponenten vermieden werden.

Des Weiteren ist zum Beschädigungsschutz bzw. zur Durchführung des Beschädigungsschutz-Verfahrens die Kenntnis über die Ist-Eigenfrequenz 46 des MEMS-Lautsprechers vorteilhaft. Gleiches gilt für die Kompensation von Verhaltensänderungen des MEMS-Lautsprechers bzw. zur Durchführung eines Kompensations-Verfahrens (vgl. Dreieckelemente 46, 47, 49).

Um die Ist-Eigenfrequenz 46 analytisch ermitteln zu können, ist ein Analyse-Aktuatorsignal 50 in der Speichereinheit der Steuereinheit 11 abgespeichert. Hierbei handelt es sich vorzugsweise um ein Rauschsignal, das sich in einem Frequenzbereich unterhalb der Resonanzfrequenz des MEMS-Lautsprechers erstreckt. Mit diesem Analyse-Aktuatorsignal 50 wird der Aktuator 7 angesteuert. Das vom Positionssensor 19 rückgemeldete Ist-Sensorsignal 37 wird von der Steuereinheit 11 analysiert, um ein Maximum innerhalb des Frequenzbereiches ermitteln zu können. Dieses Maximum identifiziert nunmehr die Ist-Eigenfrequenz 46 des MEMS-Lautsprechers. Die Steuereinheit 11 ist nunmehr derart ausgebildet, dass sie durch einen Abgleich der analytisch ermittelten Ist-Eigenfrequenz 46 mit der abgespeicherten Referenz-Eigenfrequenz 47 eine Änderung der Eigenfrequenz festzustellen vermag.

Im Falle einer erkannten Abweichung ist es zum Beschädigungsschutz vorteilhaft, wenn die neue Eigenfrequenz, d.h. die Ist-Eigenfrequenz 46, als neue Referenz-Eigenfrequenz 47 im Speicher der Steuereinheit 11 abgespeichert wird. Um eine Beschädigung des MEMS-Lautsprechers vermeiden zu können, darf dieser nämlich nur über einen begrenzten Zeitraum im Bereich der Eigenfrequenz angeregt werden. Bei der weiteren Ansteuerung der Membran 2 berücksichtigt die Steuereinheit 11 nunmehr die neue Referenz-Eigenfrequenz 47 und steuert die Membran 2 demnach in diesem Frequenzbereich zeitlich geregelt an.

Des Weiteren kann aber eine derartige Veränderung der Eigenfrequenz des MEMS-Lautsprechers auch eine Folge von äußeren Einflüssen, insbesondere Druck- oder Temperaturänderungen, oder aber auch von Alterungseffekten sein. Zur Kompensation von derartigen Verhaltensänderungen des MEMS-Lautsprechers wird bei einer analytisch festgestellten Eigenfrequenzänderung die Ist-Eigenfrequenz 46 als neue Referenz-Eigenfrequenz 47 abgespeichert und fortan bei der Ansteuerung des Aktuators 7 berücksichtigt. Hierfür steuert die Steuereinheit 11 den Aktuator 7 mit einem entsprechenden Kompensations-Aktuatorsignal 49 an.

Die vorliegende Erfindung ist nicht auf die dargestellten und beschriebenen Ausführungsbeispiele beschränkt. Abwandlungen im Rahmen des Patentanspruchs sind ebenso möglich wie eine Kombination der Merkmale, auch wenn diese in unterschiedlichen Ausführungsbeispielen dargestellt und beschrieben sind.

### Bezugszeichenliste

- 1: MEMS-Lautsprecher
- 2: Membran
- 3: Membranträger
- 4: Randbereich
- 5: Verstärkungselement
- 6: Hubstruktur
- 7: Aktuator
- 8: abgespeicherte Referenzsignale
- 9: Trägersubstrat
- 10: Leiterplatte
- 11: Steuereinheit
- 12: passive Zusatzkomponenten
- 13: Kragarm
- 14: Gehäuse
- 15: oberer Gehäuseteil
- 16: unterer Gehäuseteil
- 17: Schalleitkanal
- 18: akustische Ein-/Austrittsöffnung
- 19: Positionssensor
- 20: Sensorbereich
- 21: Aktuatorbereich
- 22: Verbindungselement
- 23: erste piezoelektrische Schicht
- 24: zweite piezoelektrische Schicht
- 25: Tragschicht
- 26: Stromleitung
- 27: erster elektrischer Kontakt
- 28: zweiter elektrischer Kontakt
- 29: fest eingespanntes Ende
- 30: erster Längsteil
- 31: zweiter Längsteil
- 32: Querteil
- 33: Widerstände
- 34: Vergleichsergebnis
- 35: Analyseergebnis
- 36: Rahmen
- 37: Ist-Sensorsignal
- 38: Ist-Standardverhalten
- 39: reduziertes Aktuatorsignal
- 40: ASIC
- 41: gemeinsame piezoelektrische Schicht
- 42: Soll-Sensorsignal
- 43: nichtlineare Oszillation
- 44: Maximalausschlag
- 45: Schwellwert
- 46: Ist-Eigenfrequenz
- 47: Referenz-Eigenfrequenz
- 48: Referenz-Aktuatorsignal
- 49: Kompensations-Aktuatorsignal
- 50: Analyse-Aktuatorsignal

## Patentansprüche

1. MEMS-Lautsprecher zum Erzeugen von Schallwellen im hörbaren Wellenlängenspektrum
mit einem Tragelement (9),
einer gegenüber dem Tragelement (9) entlang einer z-Achse auslenkbaren Membran (2),
zumindest einem sich am Tragelement (9) abstützenden piezoelektrischen Aktuator (7) zum Auslenken der Membran (2), der als Kragarm (13) ausgebildet ist und ein fest eingespanntes und ein frei schwingendes freies Ende aufweist,
einer Hubstruktur (6), über die der Aktuator (7) mit der Membran (2) verbunden ist,
einer elektronischen Steuereinheit (11) zum Ansteuern des Aktuators (7),
zumindest einem piezoelektrischen Positionssensor (19), der in den Kragarm (13) integriert ist und mittels dem der Steuereinheit (11) ein von der Membranauslenkung abhängiges Sensorsignal (37) bereitstellbar ist, und
einem elastischen Verbindungselement (22), das ein freies Ende des Positionssensors (19), der in den als Kragarm (13) ausgebildeten Aktuator (7) integriert ist, mit der Hubstruktur (6) verbindet;
wobei die Steuereinheit (11) derart ausgebildet ist,
dass sie ein Funktionsselbsttest-Verfahren automatisch durchführt, bei dem die Steuereinheit (11) zur Durchführung des Funktionsselbsttest-Verfahrens den Aktuator (7) mit einem Referenz-Aktuatorsignal (48) ansteuert,
bei dem die Steuereinheit (11) das Sensorsignal (37) zum Erhalt eines Vergleichsergebnisses (34) mit einem in der Steuereinheit (11) abgespeicherten Referenzsignal (8) abgleicht,
bei dem die Steuereinheit (11) durch den Abgleich des Sensorsignals (37) mit dem Referenzsignal (8) bei Feststellung einer Abweichung Verhaltensänderungen des MEMS-Lautsprechers (1) feststellt, nämlich eine alterungsbedingte oder durch äußere Einflüsse hervorgerufene Leistungsminderung, und
bei dem die Steuereinheit (11) den Aktuator (7) unter Berücksichtigung des Vergleichsergebnisses (34) bei festgestellter Leistungsminderung fortan mit einer die Leistungsminderung kompensierenden höheren elektrischen Spannung betreibt und geregelt ansteuert.

## Claims

1. MEMS loudspeaker for generating sound waves in the audible wavelength spectrum,
with a support element (9),
a membrane (2) deflectable with respect to the support element (9) along a z-axis,
at least one piezoelectric actuator (7) supported on the support element (9) for deflecting the membrane (2), designed as a cantilever arm (13) and having a fixedly clamped end and a freely oscillating free end,
a stroke structure (6) via which the actuator (7) is connected to the membrane (2),
an electronic control unit (11) for driving the actuator (7),
at least one piezoelectric position sensor (19), which is integrated into the cantilever arm (13) and by means of which the control unit (11) can be provided a sensor signal (37) that is dependent on the membrane deflection,and
an elastic connecting element (22) which connects a free end of the position sensor (19), which is integrated in the actuator (7) designed as a cantilever arm (13), to the stroke structure (6);
wherein the control unit (11) is designed in such a manner that the control unit performs a functional self-test process automatically, during the functional self-test process, the control unit (11) controls the actuator (7) with a reference actuator signal (48),
with which the control unit (11) compares a sensor signal (37) with a reference signal (8) stored in the control unit (11) to obtain a comparison result (34),
in which the control unit (11) detects differences in the behavior of the MEMS loudspeaker (1) by comparing the sensor signal (37) with the reference signal (8) when a deviation is detected, namely a reduction in performance due to aging or external influences, and
in which the control unit (11), by taking into account the comparison result (34), henceforth operates and controls the actuator (7) in a controlled manner with a higher electrical voltage compensating the reduction in performance when a reduction in performance is detected.

## Revendications

1. Haut-parleur MEMS destiné à générer des ondes acoustiques dans le spectre des longueurs d'onde audibles,
avec un élément porteur (9),
une membrane (2) pouvant être déviée le long d'un axe z par rapport à l'élément porteur (9),
au moins un actionneur piézoélectrique (7) s'appuyant sur l'élément porteur (9) pour faire dévier la membrane (2), qui est réalisé sous la forme d'un bras en porte-à-faux (13) et qui présente une extrémité rigidement serrée et une extrémité libre oscillant librement,
une structure de levage (6) par laquelle l'actionneur (7) est relié à la membrane (2),
une unité de commande électronique (11) pour commander l'actionneur (7),
au moins un capteur de position piézoélectrique (19), qui est intégré dans le bras en porte-à-faux (13) et au moyen duquel un signal (37)de capteur dépendant de la déviation de la membrane peut être mis à la disposition de l'unité de commande (11), et
un élément de connexion (22) élastique qui relie une extrémité libre du capteur de position (19), qui est intégré dans l'actionneur (7) conçu en tant que bras en porte-à-faux (13), à la structure de levage (6) ;
dans lequel l'unité de commande (11) est conçue de sorte que elle exécute automatiquement une procédure d'auto-test de fonctionnement,
dans lequel l'unité de commande (11) commande l'actionneur (7) avec un signal d'actionneur de référence (48) pour exécuter la procédure d'auto-test de fonctionnement,
dans lequel l'unité de commande (11) compare le signal (37) de capteur à un signal de référence (8) mémorisé dans l'unité de commande (11) pour obtenir un résultat de comparaison (34),
dans lequel l'unité de commande (11) constate des modifications de comportement du haut-parleur MEMS (1) par comparaison du signal (37) de capteur avec le signal de référence (8) lorsqu'un écart est constaté, à savoir une diminution de performance due au vieillissement ou à des influences extérieures, et
dans lequel l'unité de commande (11), en cas de diminution de performance constatée, fait fonctionner dorénavant l'actionneur (7) en tenant compte du résultat de comparaison (34), avec une tension électrique plus élevée compensant la diminution de performance et le commande de manière régulée.
